# EUROPÄISCHE PATENTSCHRIFT

(11) **EP 2 932 108 B1**
(45) Veröffentlichungstag und Bekanntmachung des Hinweises auf die Patenterteilung: **21.09.2022**
(21) Anmeldenummer: 13792905.5
(22) Anmeldetag: 18.11.2013
(51) Int. Cl.: H05K 7/14, H05K 7/20, F16B 2/24, H05K 1/05, H05K 3/00, F16B 5/06

(54) **ELEKTRISCHE KOMPONENTE MIT KÜHLKÖRPER ZU DEREN KÜHLUNG**
ELECTRIC COMPONENT WITH HEAT SINK FOR ITS COOLING
COMPOSANT ÉLECTRIQUE AVEC DISSIPATEUR THERMIQUE POUR LE REFROIDIR

(30) Priorität: 17.12.2012 DE 102012112393
(43) Veröffentlichungstag der Anmeldung: 21.10.2015
(73) Patentinhaber: Phoenix Contact GmbH & Co. KG, 32825 Blomberg (DE); Phoenix Contact Power Supplies GmbH, 33106 Paderborn (DE)
(72) Erfinder: HENKEL, Hartmut, 32825 Blomberg (DE); HEINEMANN, Michael, 32791 Lage (DE); REMMERT, Guido, 59063 Hamm (DE)
(74) Vertreter: Patentship Patentanwaltsgesellschaft mbH
(86) Internationale Anmeldenummer: PCT/EP2013/074099
(87) Internationale Veröffentlichungsnummer: WO 2014/095202

(56) Entgegenhaltungen:
- WO-A1-01/58231
- DE-A1- 2 216 162
- DE-A1- 19 531 628
- DE-A1-102005 031 395
- DE-A1-102010 005 725
- DE-B3-102007 014 713
- US-A1- 2006 089 034
- US-A1- 2007 025 108
- US-A1- 2007 211 445
- US-B1- 6 349 039
- AUDI R D: "COOLING AND MINIMIZING TEMPERATURE GRADIENT IN STACKED MODULES", IBM TECHNICAL DISCLOSURE BULLETIN,, Bd. 19, Nr. 2, 1. Juli 1976 (1976-07-01), Seite 414, XP001450397,

## Beschreibung

Die vorliegende Erfindung betrifft eine elektrische Komponente, verbunden mit einem Kühlkörper zur Kühlung der elektrischen Komponente.

Elektrische Komponenten, wie z.B. Schaltnetzteile oder andere Funktionsbaugruppen sind von Metall- oder Kunststoffgehäusen gehaust.

Metallgehäuse haben den Vorteil, dass sie gute Wärmeleiteigenschaften aufweisen. Jedoch sind Metallgehäuse elektrisch leitfähig, sodass elektrische Bauteile der elektrischen Komponente nur mit einer sehr aufwändigen elektrischen Isolierung durch Folien, Glimmerscheiben oder Keramikplättchen an das Metallgehäuse angebunden werden können. Außerdem ist es erforderlich, die Korrosionsbeständigkeit von Metallgehäusen durch galvanische Schichtabscheidungen oder Lackierungen zu verbessern, was die Fertigung aufwändiger macht.

Kunststoffgehäuse haben den Vorteil, dass vielfältige Formgebungen möglich sind. Ferner sind Kunststoffgehäuse korrosionsbeständig und einfach zu fertigen. Jedoch weisen Kunststoffgehäuse im Vergleich zu Metallgehäusen eine geringere Wärmeleitfähigkeit auf. Daher sind metallische Kühlkörper oder Lüfter zur Kühlung der elektrischen Komponenten erforderlich. An elektrische Bauteile, die Verlustleistungen in Form von Wärmeenergie abgeben, werden hierzu Kühlkörper geschraubt, geklammert oder geklebt.

Die Druckschrift Audi, R. D.: "Cooling and Minimizing Temperature Gradient in Stacked Modules", IBM Technical Disclosure Bulletin, Bd. 19, Nr. 2, Juli 1976, S. 414, betrifft eine Technik zur Kühlung und Minimierung eines Temperaturgradienten in gestapelten Modulen. Hierbei wird zur Kühlung eines gestapelten Moduls eine metallische Kappe über ein Substrat des gestapelten Moduls gestülpt. Ferner ist zwischen dem Substrat und der metallischen Kappe ein leitendes Elastomer vorgesehen.

Die Druckschrift WO 01/58231 A1 betrifft eine Kühlvorrichtung zum Kühlen von einer oder mehreren Elektronik-Komponenten, mit wenigstens einem Kühlkörper, der der Elektronik-Komponente zugeordnet ist und mit dieser in wärmeleitender Verbindung steht.

Die Druckschrift DE 10 2005 031 395 A1 betrifft ein Verfahren zum Befestigen eines Anbauteils an einem Kunststoffbauteil.

Die Druckschrift US 2007/0025108 A1 betrifft eine flexible Schaltung mit einer rollgegossenen thermoplastischen Harz-Basisplatte und integrierter Montagestruktur zur Aufnahme einer LED.

Die Druckschrift US 2007/211445 A1 betrifft eine Wärmeregulierungsvorrichtung mit einer Federklammer zur Kühlung von elektronischen Bauteilen.

Die Druckschrift AT 371 948 B10 betrifft eine Kühlvorrichtung zur Kühlung von Transistoren.

Die Druckschrift DE 10 2005 002 812 A1 betrifft einen Kühlkörper zur Kühlung von oberflächenmontierten Halbleiterbauteilen.

Die Druckschrift DE 195 31 628 A1 offenbart einen Kühlkörper für elektronische Bauelemente.

Die Druckschrift DE 22 16 162 A1 offenbart einen Kühlkörper für eine Halbleitereinrichtung.

Die Druckschrift DE 10 2007 014 713 B3 offenbart eine Kühlanordnung.

Es ist daher die Aufgabe der vorliegenden Erfindung, einen Kühlkörper bereitzustellen, der einfacher zu montieren ist.

Diese Aufgabe wird durch den Gegenstand mit den Merkmalen nach dem unabhängigen Anspruch gelöst. Vorteilhafte Ausführungsformen sind Gegenstand der abhängigen Ansprüche, der Beschreibung und der Zeichnungen.

Die vorliegende Erfindung basiert auf der Erkenntnis, dass die Montage vereinfacht werden kann, wenn der Kühlkörper zumindest teilweise elastisch verformbar ist.

Gemäß einem ersten Aspekt wird die Aufgabe durch eine elektrische Komponente, verbunden mit einem Kühlkörper zur Kühlung der elektrischen Komponente gelöst, mit:
- einer Kontaktfläche, die in wärmeleitendem Kontakt mit einer Gegenkontaktfläche der elektrischen Komponente gebracht ist;
- wobei die Kontaktfläche zumindest einen elastisch verformbaren Abschnitt aufweist.

Dadurch wird der technische Vorteil erreicht, dass durch elastische Verformung des elastischen Abschnitts ein Anpressdruck bereitgestellt wird, der sicherstellt, dass die Kontaktfläche und die Gegenkontaktfläche in Kontakt bleiben und so eine wärmeleitende Verbindung bilden, durch die z.B. elektrische Bauteile der elektrischen Komponenten entwärmt werden.

In einer vorteilhaften Ausführungsform ist durch elastische Verformung des elastisch verformbaren Abschnitts ein Flächenanteil der Kontaktfläche, der mit der Gegenkontaktfläche in Kontakt steht, vergrößerbar. Dadurch wird der technische Vorteil erreicht, dass durch Vergrößerung des Flächenanteils der Wärmeleitwiderstand der wärmeleitenden Verbindung minimiert wird.

Erfindungsgemäß ist die Kontaktfläche konvex gekrümmt. Dadurch wird der technische Vorteil erreicht, dass der Kühlkörper einfach zu fertigen und zu montieren ist.

In einer vorteilhaften Ausführungsform ist die Kontaktfläche durch elastische Verformung abflachbar. Dadurch wird der technische Vorteil erreicht, dass ein besonders inniger Kontakt zwischen der Kontaktfläche und der Gegenkontaktfläche erreicht wird, insbesondere im Bereich der Abflachung. So wird der Wärmeleitwiderstand der wärmeleitenden Verbindung nochmals minimiert.

Erfindungsgemäß weist der Kühlkörper eine Aufnahme für die elektrische Komponente auf. Dadurch wird der technische Vorteil erreicht, dass keine zusätzlichen Befestigungsmittel, wie z.B. Schrauben oder Klammern, nötig sind, um den Kühlkörper an der elektrischen Komponente zu befestigen.

Erfindungsgemäß fixiert die Aufnahme bei Kontakt der Kontaktfläche mit der Gegenkontaktfläche den elastisch verformbaren Abschnitt in einem elastisch verformten Zustand. Dadurch wird der technische Vorteil erreicht, dass zusätzlich zur Befestigung des Kühlkörpers an der elektrischen Komponente ein inniger Kontakt der Kontaktfläche mit der Gegenkontaktfläche gewährleistet ist.

In einer vorteilhaften Ausführungsform ist die Aufnahme ausgebildet, Abschnitte der elektrischen Komponente u-förmig zu umgreifen. Dadurch wird der technische Vorteil erreicht, dass der Kühlkörper mit der Aufnahme besonders einfach zu fertigen ist.

In einer vorteilhaften Ausführungsform ist der Kühlkörper aus Kunststoff gefertigt. Dadurch wird der technische Vorteil erreicht, dass der Kühlkörper aus einem leicht zu verarbeitenden, korrosionsbeständig und elektrisch isolierenden Material gefertigt ist, was die Fertigung vereinfacht.

In einer vorteilhaften Ausführungsform ist das Gehäuse aus faserverstärktem Kunststoff gefertigt. Dadurch wird der technische Vorteil erreicht, dass die Wärmeleitfähigkeit des faserverstärkten Kunststoffs durch die Fasern gesteigert ist.

In einer vorteilhaften Ausführungsform ist das Gehäuse aus Kunststoff gefertigt, das zumindest eines der folgenden Materialien enthält: Keramiken, Oxide, keramische Oxide, Metalloxide. Dadurch wird der technische Vorteil erreicht, dass die Wärmeleitfähigkeit des faserverstärkten Kunststoffs nochmals gesteigert ist.

Erfindungsgemäß weist der Kühlkörper eine weitere Oberfläche auf, die als Wärmeabstrahlfläche ausgebildet ist. Dadurch wird der technische Vorteil erreicht, dass die Wärme gezielt von dem Kühlkörper in Form von IR-Strahlung abgestrahlt wird. So wird die Kühlwirkung des Kühlkörpers gesteigert.

Erfindungsgemäß weist die Wärmeabstrahlfläche ihre Oberfläche vergrößernde Erhebungen auf. Dadurch wird der technische Vorteil erreicht, dass die Kühlwirkung des Kühlkörpers nochmals gesteigert wird.

Erfindungsgemäß ist der Kühlkörper zumindest als ein Gehäuseabschnitt eines Gehäuses ausgebildet, das die elektrische Komponente haust. Dadurch wird der technische Vorteil erreicht, dass der Kühlkörper die elektrische Komponente zusätzlich vor Schmutz und/oder Feuchtigkeit schützt.

Gemäß dem ersten Aspekt wird die Aufgabe durch die elektrische Komponente, verbunden mit einem derartigen Kühlkörper, gelöst. Dadurch wird der technische Vorteil erreicht, dass durch elastische Verformung des elastischen Abschnitts ein Anpressdruck bereitgestellt wird, der sicherstellt, dass die Kontaktfläche und die Gegenkontaktfläche in Kontakt bleiben und so eine wärmeleitende Verbindung bilden, durch die z.B. elektrische Bauteile der elektrischen Komponenten entwärmt werden.

Weitere Ausführungsbeispiele werden Bezug nehmend auf die beiliegenden Zeichnungen erläutert. Es zeigen:
Fig. 1 eine perspektivische Ansicht einer elektrischen Baugruppe mit diversen elektrischen Komponenten;
Fig. 2 eine perspektivische Ansicht eines mehrschichtigen Trägers mit einer elektrischen Komponente;
Fig. 3 eine weitere perspektivische Ansicht eines mehrschichtigen Trägers mit einer elektrischen Komponente; und
Fig. 4 eine Schnittdarstellung eines Gehäuseteils;
Fig. 5 eine Schnittdarstellung eines Gehäuses/Kühlkörpers und eines mehrschichtigen Trägers; und
Fig. 6 eine Schnittdarstellung eines weiteren Kühlkörpers mit einer elektrischen Baugruppe.

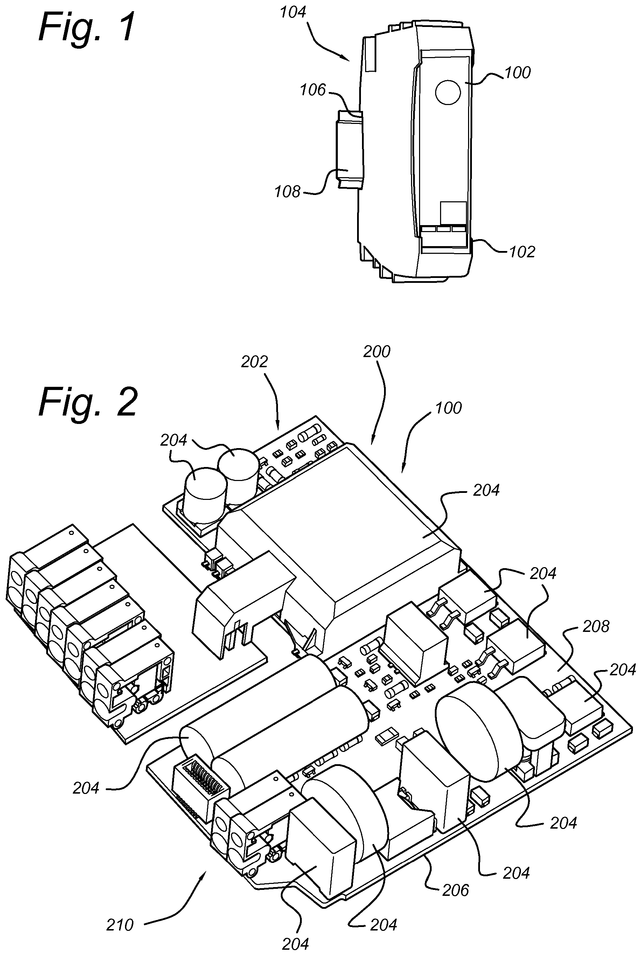

Fig. 1 zeigt ein Schaltnetzteil als Ausführungsbeispiel für eine elektrische Baugruppe 100. Die elektrische Baugruppe 100 weist ein Gehäuse 102 auf, das im vorliegenden Ausführungsbeispiel an seiner Rückseite 104 eine Rasteinrichtung 106 aufweist, mit der es auf einer Hutschiene 108 verrastet ist.

Fig. 2 zeigt ein Ausführungsbeispiel einer elektrischen Komponente 200 der elektrischen Baugruppe 100. Die elektrische Komponente 200 ist im vorliegenden Ausführungsbeispiel zur Stromversorgung ausgebildet. Hierzu ist im vorliegenden Ausführungsbeispiel die elektrische Komponente 200 als Schaltnetzteil 202 ausgebildet.

Die elektrische Komponente 200 umfasst im vorliegenden Ausführungsbeispiel eine Mehrzahl von elektrischen Bauteilen 204, die im vorliegenden Ausführungsbeispiel auf einem mehrschichtigen Träger 206 angeordnet und entsprechend verschaltet sind. Der mehrschichtige Träger weist eine Oberseite 208 auf, auf der die elektrischen Bauteile 204 angeordnet sind, sowie eine der Oberseite 208 gegenüberliegende Unterseite auf, die wie später noch erläutert wird, als Gegenkontaktfläche 210 ausgebildet ist.

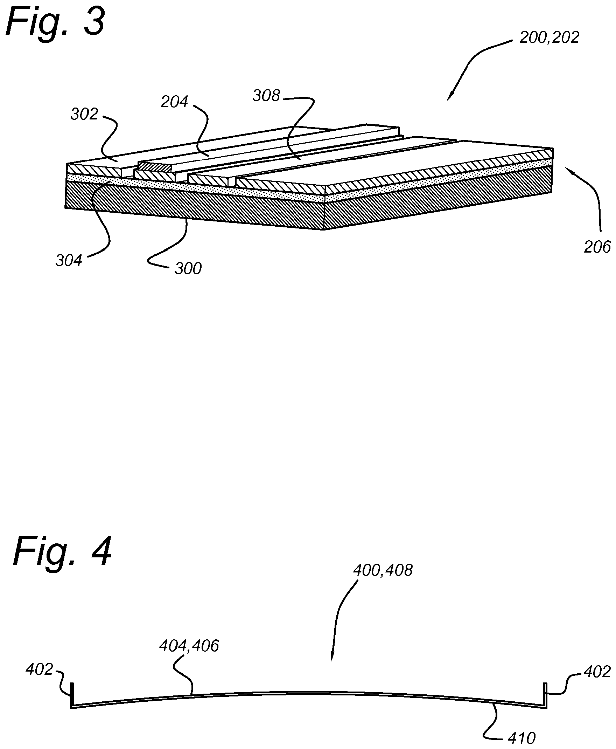

Fig. 3 zeigt ein Ausführungsbeispiel eines mehrschichtigen Trägers 206 für das Schaltnetzteil 202. Im vorliegenden Ausführungsbeispiel ist der mehrschichtige Träger 206 ein Copper-Clad-Träger.

Der mehrschichtige Träger 206 weist im vorliegenden Ausführungsbeispiel eine Metallplatte 300, eine Leiterbahnschicht 302 zur elektrischen Kontaktierung von elektrischen Bauteilen 204 der elektrischen Komponente 200 bzw. des Schaltnetzteils 202 und eine elektrische Isolationsschicht 304 auf, welche zwischen der Metallplatte 300 und der Leiterbahnschicht 302 angeordnet ist.

Im vorliegenden Ausführungsbeispiel ist die Metallplatte 300 aus Aluminium oder Kupfer, oder aus einer Legierung gebildet, die Aluminium oder Kupfer enthält. Ferner schirmt im vorliegenden Ausführungsbeispiel die Metallplatte 300 elektromagnetische Wechselfelder ab, die bei Betrieb des Schaltnetzteils 202 von den elektrischen Bauteilen 204 abgestrahlt werden. Hierzu ist im vorliegenden Ausführungsbeispiel die Metallplatte 300 vollflächig ausgebildet, d.h. sie weist keine Bohrungen oder Durchbrüche auf, die sich durch ihre Dicke erstrecken. Um einen Einsatz des Schaltnetzteils 202 auch in einem EMV-sensitiven Umfeld zu ermöglichen ist die Metallplatte 300 zur Abschirmung elektromagnetischer Wechselfelder mit einer Frequenz von bis zu 30 MHz ausgebildet ist, da elektromagnetische Wechselfelder mit derartigen Frequenzen beim Betrieb des Schaltnetzteils 202 auftreten können.

Die Leiterbahnschicht 302 bildet Leiterbahnen 308, die der elektrischen Kontaktierung von elektrischen Bauteilen 204 dienen. Im vorliegenden Ausführungsbeispiel ist die Leiterbahnschicht 302 aus Aluminium oder Kupfer, oder aus einer Legierung gebildet, die Aluminium oder Kupfer enthält.

Die elektrische Isolationsschicht 304 ist im vorliegenden Ausführungsbeispiel eine thermisch leitende Dielektrikumsschicht. So wird eine gut wärmeleitende Verbindung zwischen den elektrischen Bauteilen 204 und der Metallplatte 300 gebildet, um Wärmeenergie von der elektrischen Komponente 200 abzuführen.

Fig. 4 zeigt ein Ausführungsbeispiel für einen Kühlkörper 400 zur Kühlung der elektrischen Komponente 200. Der Kühlkörper 400 ist im vorliegenden Ausführungsbeispiel als Gehäuseabschnitt 410 eines Gehäuses 408 zur Hausung der elektrischen Komponente 200 ausgebildet, und kann mit einem weiteren Teilgehäuse (nicht dargestellt), das als Deckel ausgebildet ist, verschlossen werden.

Der Kühlkörper 400 ist im vorliegenden Ausführungsbeispiel einstückig und materialeinheitlich aus faserverstärktem Kunststoff gefertigt, wobei dem Kunststoffmaterial ferner im vorliegenden Ausführungsbeispiel Glasfasern, Keramiken, Oxide, keramische Oxide, Metalloxide hinzugefügt wurden, um die Wärmeleitfähigkeit weiter zu steigern und damit die Kühlwirkung des Kühlkörpers 400 zu optimieren.

Der Kühlkörper 400 weist im vorliegenden Ausführungsbeispiel zwei seitliche Begrenzungen 402 auf, die, wie noch später beschrieben wird, der Positionierung einer elektrischen Komponente 200 dienen. Ferner weist im vorliegenden Ausführungsbeispiel der Kühlkörper 400 eine Kontaktfläche 404 auf, die in wärmeleitendem Kontakt mit einer der Gegenkontaktfläche 210 des Trägers 206 der elektrischen Komponente 200 gebracht werden kann, um die elektrische Komponente 200 zu entwärmen und dadurch zu kühlen.

Im vorliegenden Ausführungsbeispiel ist die Kontaktfläche 404 als elastisch verformbarer Abschnitt 406 des Kühlkörpers 400 ausgebildet. Der elastisch verformbare Abschnitt 406 ist im vorliegenden Ausführungsbeispiel händisch verformbar ausgebildet. Es ist somit eine Verformung ohne Werkzeug- oder Maschineneinsatz möglich. Im Ausgangszustand, wie in Fig. 4 dargestellt, ist die Kontaktfläche 404 konvex gekrümmt ausgebildet. Nach der Montage, also im montierten Zustand, ist die Kontaktfläche 404 im vorliegenden Ausführungsbeispiel im Vergleich zum Ausgangszustand in einem Flächenabschnitt durch elastische Verformung abgeflacht, wie noch später erläutert wird.

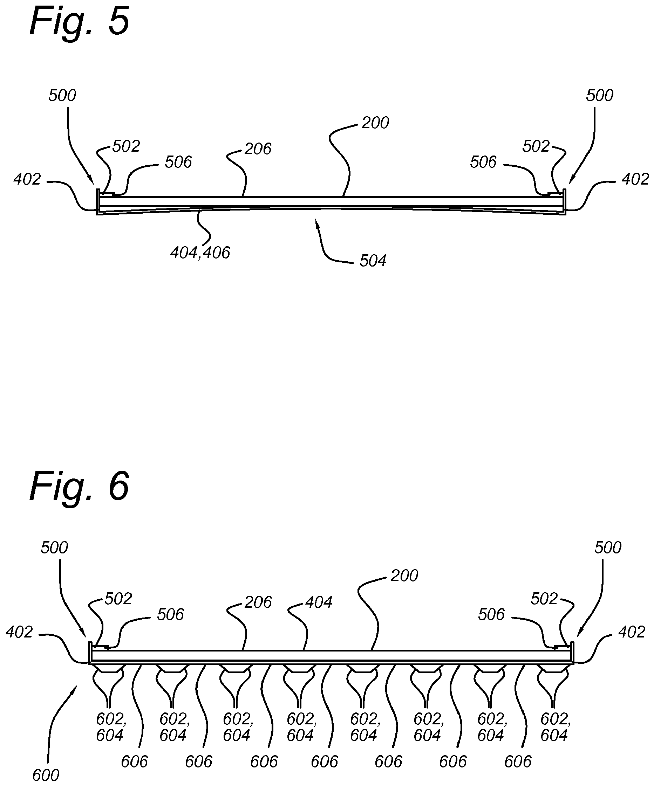

Fig. 5 zeigt ein weiteres Ausführungsbeispiel für einen Kühlkörper 400 zur Kühlung der elektrischen Komponente 200.

Der in Fig. 5 dargestellte Kühlkörper 400 weist den gleichen Aufbau wie der in Fig. 4 dargestellte Kühlkörper 400 auf, bis auf den Unterschied, dass der Kühlkörper 400 gemäß der Fig. 5 eine Aufnahme 500 für die elektrische Komponente 200 aufweist.

Die Aufnahme 500 umfasst im vorliegenden Ausführungsbeispiel je eine an die beiden Begrenzungen 402 angeformte Halteschiene 502, die im vorliegenden Ausführungsbeispiel die gleiche Erstreckungsrichtung wie die Begrenzungen 402 aufweisen. Die Halteschienen 502 sind im vorliegenden Ausführungsbeispiel wie die Begrenzungen 402 und aus dem gleichen Material wie die Begrenzungen 402 gefertigt. Somit ist im vorliegenden Ausführungsbeispiel der Kühlkörper 400 mit den Begrenzungen 402 und den Halteschienen 502 einstückig und materialeinheitlich aus faserverstärktem Kunststoff gefertigt, dem im vorliegenden Ausführungsbeispiel Keramiken, Oxide, keramische Oxide, Metalloxide hinzugefügt wurden, um die Wärmeleitfähigkeit weiter zu steigern.

Die Fig. 5 zeigt ferner, dass der Kühlkörper 500 mit der elektrischen Komponente 200 verbunden wurde.

Die Kontaktfläche 404 steht mit einem Flächenabschnitt 504 in unmittelbaren Kontakt mit der Gegenkontaktfläche 210 des Trägers 206. So kann Wärmeenergie von elektrischen Bauteilen 204 durch den Träger 206 zu dem Kühlkörper 400 abgeführt werden. Zu erkennen ist ferner, dass der Kühlkörper 400 in geringerem Umfang konvex gekrümmt ist. So wird ein Flächenanteil 504 der Kontaktfläche 404, der mit der Gegenkontaktfläche 210 durch die Montage des Kühlkörpers 400 in Kontakt gebracht wird, vergrößert und so die wärmeleitfähige Verbindung zwischen dem Kühlkörper 400 und der elektrische Komponente 200 verbessert. Dabei wird während der Montage der Kühlkörper 400 mit seiner Kontaktfläche 404 auf die Gegenkontaktfläche 210 gedrückt.

Die beiden Halteschienen 502 stehen im vorliegenden Ausführungsbeispiel in Kontakt mit Randabschnitten 506 des Trägers 206. Somit umgreifen die Halteschienen 502 den Träger 206 im vorliegenden Ausführungsbeispiel u-förmig. Durch diesen Kontakt der Randabschnitte 506 mit den Halteschienen 502 wird der elastische Abschnitt 406 so verformt, dass der elastisch verformbare Abschnitt 406 abgeflacht ist und in flächigem Kontakt mit der Gegenkontaktfläche 210 steht.

Fig. 6 zeigt ein weiteres Ausführungsbeispiel für einen Kühlkörper 400 zur Kühlung der elektrischen Komponente 200.

Der in Fig. 6 dargestellte Kühlkörper 200 weist den gleichen Aufbau wie der in Fig. 5 dargestellte Kühlkörper 400 auf, bis auf den Unterschied, dass die Kontaktfläche 404 vollflächig in Kontakt mit der Gegenkontaktfläche 210 des Trägers 206 steht, so dass der Wärmeübertrag von dem Träger 206 auf den Kühlkörper 400 maximiert ist.

Ferner weist der in Fig. 6 dargestellte Kühlkörper 200 eine als Wärmeabstrahlfläche 600 ausgebildete Rückseite auf. Hierzu weist die Wärmeabstrahlfläche 600 im vorliegenden Ausführungsbeispiel Erhebungen 602 auf, die die Oberfläche der Wärmeabstrahlfläche 600 vergrößern und so die Entwärmung von elektrischen Bauteilen 204 verbessert. Dabei ist im vorliegenden Ausführungsbeispiel die Wärmeabstrahlfläche 600 ausgebildet, Wärmeenergie in Form von IR-Strahlung abzugeben.

Hierzu sind im vorliegenden Ausführungsbeispiel die Erhebungen 602 so ausgebildet, dass die abgegebene IR-Strahlung nicht wieder auf die Wärmeabstrahlfläche 600 trifft. Im vorliegenden Ausführungsbeispiel weisen die Erhebungen 602 hierzu Phasen 604 mit einem Winkel von 45° zur Ebene der Wärmeabstrahlfläche 600 bzw. der Kontaktfläche 404 auf, die zwischen Abschnitten 606 der Wärmeabstrahlfläche 600 angeordnet sind, deren Ebenen parallel zu der Ebene der Wärmeabstrahlfläche 600 bzw. der Kontaktfläche 404 sind. Dabei sind im vorliegenden Ausführungsbeispiel die Abschnitte 606 auf unterschiedlichen Höhenniveaus angeordnet.

Zur Montage wird der Kühlkörper 400 soweit verformt, dass der verformbare Abschnitt 406 der Kontaktfläche 404 einen so geringen Grad an Konvexität aufweist, dass der Träger 206 mit seinen Randabschnitten 506 problemlos in die Zwischenräume zwischen den Halteschienen 502 und der Kontaktfläche 404 eingeführt werden kann. In einem nächsten Schritt wird der Träger 206 soweit verlagert, bis die Kontaktfläche 404 und die Gegenkontaktfläche 210 des Trägers 206 sich vollständig überdecken, so dass die Kontaktfläche 404 vollflächig in Kontakt mit der Gegenkontaktfläche des Trägers 206 steht und der Wärmeübertrag von dem Träger 206 auf den Kühlkörper 400 maximiert ist. Somit ist eine einfache Montage ohne zusätzliche Befestigungsmittel möglich.

Alle in Verbindung mit einzelnen Ausführungsformen der Erfindung erläuterten und gezeigten Merkmale können in unterschiedlicher Kombination in dem erfindungsgemäßen Gegenstand vorgesehen sein, um gleichzeitig deren vorteilhafte Wirkungen zu realisieren.

Der Schutzbereich der vorliegenden Erfindung ist durch die Ansprüche gegeben und wird durch die in der Beschreibung erläuterten oder den Figuren gezeigten Merkmale nicht beschränkt.

### BEZUGSZEICHENLISTE

- 100: elektrische Baugruppe
- 102: Gehäuse
- 104: Rückseite
- 106: Rasteinrichtung
- 108: Hutschiene

- 200: Elektrische Komponente
- 202: Schaltnetzteil
- 204: elektrisches Bauteil
- 206: Träger
- 208: Oberseite
- 210: Gegenkontaktfläche

- 300: Metallplatte
- 302: Leiterbahnschicht
- 304: elektrische Isolationsschicht
- 308: Leiterbahn

- 400: Kühlkörper
- 402: Begrenzungen
- 404: Kontaktfläche
- 406: verformbarer Abschnitt
- 408: Gehäuse
- 410: Gehäuseabschnitt

- 500: Aufnahme
- 502: Halteschiene
- 504: Flächenanteil
- 506: Randabschnitt

- 600: Wärmeabstrahlfläche
- 602: Erhebungen
- 604: Phase
- 606: Abschnitt

## Patentansprüche

1. Elektrische Komponente (200), verbunden mit einem Kühlkörper (400) zur Kühlung der elektrischen Komponente (200), mit:
- einer Kontaktfläche (404), die in wärmeleitendem Kontakt mit einer Gegenkontaktfläche (210) der elektrischen Komponente (200) gebracht ist;
- wobei die Kontaktfläche (404) zumindest einen elastisch verformbaren Abschnitt (406) aufweist;
wobei der Kühlkörper (400) eine Aufnahme (500) für die elektrische Komponente (200) aufweist;
wobei die Aufnahme (500) bei Kontakt der Kontaktfläche (404) mit der Gegenkontaktfläche (210) den elastisch verformbaren Abschnitt (406) in einem elastisch verformten Zustand fixiert;
- wobei der Kühlkörper (400) eine weitere Oberfläche aufweist, die als Wärmeabstrahlfläche (600) ausgebildet ist;
- wobei die Wärmeabstrahlfläche (600) ihre Oberfläche vergrößernde Erhebungen (602) aufweist;
- wobei der Kühlkörper (400) zumindest als ein Gehäuseabschnitt (410) eines Gehäuses (408) ausgebildet ist, das die elektrische Komponente (200) haust,
- wobei die Kontaktfläche (404) konvex gekrümmt ist, und
- wobei die elektrische Komponente (200) eine Mehrzahl von elektrischen Bauteilen (204) umfasst, die auf einem mehrschichtigen Träger (206) angeordnet und entsprechend verschaltet sind, wobei der mehrschichtige Träger (206) eine Oberseite (208) aufweist, auf der die elektrischen Bauteile (204) angeordnet sind sowie eine der Oberseite (208) gegenüberliegende Unterseite aufweist, die als Gegenkontaktfläche (210) ausgebildet ist.

2. Elektrische Komponente (200) nach Anspruch 1, wobei durch elastische Verformung des elastisch verformbaren Abschnitts (406) ein Flächenanteil (404) der Kontaktfläche (404), der mit der Gegenkontaktfläche (210) in Kontakt steht, vergrößerbar ist.

3. Elektrische Komponente (200) nach einem der vorstehenden Ansprüche, wobei die Kontaktfläche (404) durch elastische Verformung abflachbar ist.

4. Elektrische Komponente (200) nach einem der vorstehenden Ansprüche, wobei die Aufnahme (500) ausgebildet ist, Randabschnitte (506) der elektrischen Komponente (200) u-förmig zu umgreifen.

5. Elektrische Komponente (200) nach einem der vorstehenden Ansprüche, wobei der Kühlkörper (400) aus Kunststoff gefertigt ist.

6. Elektrische Komponente (200) nach Anspruch 5, wobei der Kühlkörper (400) aus faserverstärktem Kunststoff gefertigt ist.

7. Elektrische Komponente (200) nach Anspruch 5 oder 6, wobei der Kühlkörper (400) aus Kunststoff gefertigt ist, das zumindest eines der folgenden Materialien enthält: Keramiken, Oxide, keramische Oxide, Metalloxide.

## Claims

1. Electrical component (200) connected to a heat sink (400) for cooling the electrical component (200), comprising:
- a contact surface (404) which is brought into thermally conductive contact with a counter contact surface (210) of the electrical component (200);
- wherein the contact surface (404) comprises at least one elastically deformable section (406);
wherein the heat sink (400) comprises a receptacle (500) for the electrical component (200);
wherein the receptacle (500) fixes the elastically deformable section (406) in an elastically deformed state when the contact surface (404) contacts the counter contact surface (210);
- wherein the heat sink (400) comprises a further surface which is configured as a heat radiating surface (600);
- wherein the heat radiating surface (600) comprises elevations (602) increasing its surface area;
- wherein the heat sink (400) is configured at least as a housing section (410) of a housing (408), which houses the electrical component (200),
- wherein the contact surface (404) is convexly curved, and
- wherein the electrical component (200) comprises a plurality of electrical elements (204), which are arranged on a multi-layer carrier (206) and are connected accordingly, wherein the multi-layer carrier (206) comprises an upper side (208) on which the electrical elements (204) are arranged and a lower side facing the upper side (208), which lower side is configured as a counter contact surface (210).

2. Electrical component (200) according to claim 1, wherein a surface part (404) of the contact surface (404), which is in contact with the counter contact surface (210), is enlargeable by elastic deformation of the elastically deformable section (406).

3. Electrical component (200) according to any one of the preceding claims, wherein the contact surface (404) is flattenable by elastic deformation.

4. Electrical component (200) according to any one of the preceding claims, wherein the receptacle (500) is configured to encompass edge sections (506) of the electrical component (200) in a U-shaped manner.

5. Electrical component (200) according to any one of the preceding claims, wherein the heat sink (400) is made of plastic.

6. Electrical component (200) according to claim 5, wherein the heat sink (400) is made of fiber-reinforced plastic.

7. Electrical component (200) according to claim 5 or 6, wherein the heat sink (400) is made of plastic, which comprises at least one of the following materials: ceramics, oxides, ceramic oxides, metal oxides.

## Revendications

1. Composant électrique (200) relié à un dissipateur thermique (400) destiné à refroidir le composant électrique (200), ledit composant électrique comprenant :
- une surface de contact (404) qui est amenée en contact thermoconducteur avec une surface de contact homologue (210) du composant électrique (200) ;
- la surface de contact (404) comportant au moins une portion élastiquement déformable (406) ;
le dissipateur thermique (400) comportant un réceptacle (500) destiné au composant électrique (200) ;
le réceptacle (500) fixant la portion élastiquement déformable (406) dans un état élastiquement déformé lorsque la surface de contact (404) vient en contact avec la surface de contact homologue (210) ;
- le dissipateur thermique (400) comportant une autre surface qui est conçue comme une surface de rayonnement thermique (600) ;
- la surface de rayonnement thermique (600) comportant des élévations (602) qui augmentent sa superficie ;
- le dissipateur thermique (400) étant conçu au moins comme une portion de boîtier (410) d'un boîtier (408) qui loge le composant électrique (200),
- la surface de contact (404) étant incurvée de manière convexe, et
- le composant électrique (200) comprenant une pluralité de composants électriques (204) qui sont disposés sur un support multicouche (206) et qui montés de manière appropriée, le support multicouche (206) comportant une face supérieure (208) sur laquelle les composants électriques (204) sont disposés, ainsi qu'une face inférieure qui est opposée à la face supérieure (208) et qui est conçue comme une surface de contact homologue (210).

2. Composant électrique (200) selon la revendication 1, une fraction de surface (404) de la surface de contact (404) qui est en contact avec la surface de contact homologue (210) pouvant être agrandie par déformation élastique de la portion élastiquement déformable (406).

3. Composant électrique (200) selon l'une des revendications précédentes, la surface de contact (404) pouvant être aplatie par déformation élastique.

4. Composant électrique (200) selon l'une des revendications précédentes, le réceptacle (500) étant conçu pour s'engager en forme de U autour des portions de bord (506) du composant électrique (200).

5. Composant électrique (200) selon l'une des revendications précédentes, le dissipateur thermique (400) étant en matière synthétique.

6. Composant électrique (200) selon la revendication 5, le dissipateur thermique (400) étant réalisé en matière synthétique renforcée par de fibres.

7. Composant électrique (200) selon la revendication 5 ou 6, le dissipateur thermique (400) étant réalisé en matière synthétique qui contient au moins une des matières suivantes : des céramiques, des oxydes, des oxydes céramiques, des oxydes métalliques.
